## Europäisches Patentamt

## European Patent Office

## Office européen des brevets

(19)

(11) **EP 0 981 859 B1**

(12) **EUROPÄISCHE PATENTSCHRIFT**

(45) Veröffentlichungstag und Bekanntmachung des Hinweises auf die Patenterteilung:
**11.02.2004 Patentblatt 2004/07**

(21) Anmeldenummer: **98966776.1**

(22) Anmeldetag: **16.12.1998**

(51) Int Cl.⁷: **H03K 5/1252**

(86) Internationale Anmeldenummer:
**PCT/DE1998/003699**

(87) Internationale Veröffentlichungsnummer:
**WO 1999/033176 (01.07.1999 Gazette 1999/26)**

(54) **VERFAHREN UND ELEKTRISCHE SCHALTUNG ZUR TOTZEITREGELUNG BEI VARIIERENDEN IMPULSFREQUENZEN**

METHOD AND ELECTRICAL CIRCUIT FOR DELAY TIME REGULATION IN VARYING PULSE RECURRENCE FREQUENCIES

PROCEDE ET CIRCUIT ELECTRIQUE POUR LA REGULATION DU TEMPS DE RETARD DANS DES FREQUENCES VARIABLES DE RECURRENCE DES IMPULSIONS

(84) Benannte Vertragsstaaten:
**DE ES FR GB IT SE**

(30) Priorität: **19.12.1997 DE 19756664**

(43) Veröffentlichungstag der Anmeldung:
**01.03.2000 Patentblatt 2000/09**

(73) Patentinhaber: **MTU Aero Engines GmbH
80995 München (DE)**

(72) Erfinder:
• **ZIELINSKI, Michael
D-85716 Unterschleissheim (DE)**
• **ZILLER, Gerhard
D-85221 Dachau (DE)**

(74) Vertreter: **Zacharias, Frank L.
DaimlerChrysler AG
Intellectual Property Management
IPM/A HPC:C 106
70546 Stuttgart (DE)**

(56) Entgegenhaltungen:
**DE-A- 4 411 027          US-A- 4 349 754**

**Beschreibung**

Die Erfindung bezieht sich auf ein Verfahren zur Umwandlung pulsförmiger, stark strukturierter Analogsignale in Triggerimpulse mittels einer Elektronik, wobei diese für eine bestimmte Zeit, die sogenannte Totzeit, verriegelt wird, sowie auf eine elektrische Schaltung zur Durchführung des Verfahrens.

Bei verschiedenen Messungen werden zeitlich hochgenaue Triggerimpulse benötigt, die aus dem Signalanstieg von Analogsignalen abgeleitet werden. So werden z. B. zeitlich hochgenaue Positionssignale der Laufschaufeln von Turbomaschinen benötigt, wozu optische Sonden eingesetzt werden und die Schaufeln einen von der Sonde aufbereiteten Beleuchtungsstrahl durchlaufen und die Analogsignale aus dem von der Schaufelstirnfläche reflektierten Licht gewonnen werden. Die unregelmäßige Oberflächenstruktur der Schaufelstirnflächen kann zu zerklüfteten Analogsignalen führen, bei denen Einbrüche bis auf null möglich sind.

Nach dem Stand der Technik wird zur Umwandlung der Analogsignale in Triggerimpulse dort, wo das Analogsignal einen bestimmten Schwellwert überschreitet, mit einer Triggerelektronik der Beginn eines Triggerimpulses abgeleitet, der beim Unterschreiten des Schwellwertes wieder beendet wird. Bei stark zerklüfteten Analogsignalen, die Einbrüche bis auf null aufweisen, kommt es bei einem derartigen Verfahren zu Fehltriggerungen, da ein einziges Analogsignal nicht in einen langen Triggerimpuls, sondern in mehrere kürzere Teilimpulse umgewandelt wird.

Zur Verhinderung von Mehrfachtriggerungen wird bei diesem bekannten Verfahren die Triggerelektronik nach jeder erfolgten Triggerung für eine bestimmte Zeit, die sogenannte Totzeit, verriegelt, wobei die Totzeit hier manuell auf einen festen Wert eingestellt wird.

Nachteilig wirkt sich dabei aus, dass zur Vermeidung von Impulsausfällen die Totzeit kleiner gewählt werden muss als der kürzeste zu erwartende zeitliche Abstand der Analogsignale. Dies hat zur Folge, dass mit abnehmenden Signalfrequenzen und entsprechend länger werdenden Analogsignalen diese nicht mehr vollständig von der Totzeit abgedeckt werden und es zu Mehrfachtriggerungen kommt.

Die DE 4411027 A1 offenbart eine Schaltungsanordnung zur Signalaufbereitung von periodischen Signalen, insbesondere mit variabler Frequenz, bei der zur optimalen Störimpulsunterdrückung die Setzzeit eines monostabilen Kippglieds, das aufgrund einer auftretenden Flanke an einem Eingang der Schaltungsanordnung für eine definierte Zeit gesetzt wird, in Abhängigkeit von der Frequenz der periodischen Signale vorgebbar ist.

Die Aufgabe der vorliegenden Erfindung ist es, ein Verfahren zur Umwandlung pulsförmiger, stark strukturierter Analogsignale in Triggerimpulse mittels einer für die Totzeit zu verriegelnden Elektronik anzugeben, so dass ohne weitere manuelle Einstellung unter allen Betriebsbedingungen zu jedem Analogsignal genau ein Triggerimpuls gebildet wird.

Die Lösung der Aufgabe wird erfindungsgemäß durch die kennzeichnenden Merkmale von Anspruch 1 gelöst.

Durch das erfindungsgemäße Verfahren braucht bei der Umwandlung von Analogsignalen mit variierender Pulsfrequenz nicht mehr manuell in die Messung eingegriffen werden, was die Umwandlung unsensibler macht gegenüber starken Pulsfrequenzänderungen innerhalb einer Messung und Mehrfachtriggerungen bzw. Impulsausfälle unterbindet.

Vorteilhaft werden die Analogsignale, solange sie einen Schwellwert überschreiten, in Rohimpulse einer definierten Spannung umgewandelt, die anschließend in Triggerimpulse mit veränderlicher Impulslänge und fester Impulshöhe überführt werden. Dabei bildet die steile Flanke der Triggerimpulse eine zeitlich hochgenaue Marke. Die Impulslänge, die der Totzeit entspricht, wird bevorzugt durch ein Stellsignal bestimmt, welches durch einen Vergleich des zeitlichen Mittelwerts der Folge der Triggerimpulse mit einem Referenzsignal erzeugt wird.

Bei einer bevorzugten Überführung der Triggerimpulse in Endimpulse werden aus den ansteigenden Flanken der Triggerimpulse Endimpulse abgeleitet, so das Signale mit einer definierten Höhe und einer definierten Breite entstehen, was für manche Anwendungen von Vorteil sein kann.

Das Referenzsignal, das bevorzugt zum Vergleich mit dem zeitlichen Mittelwert der Folge der Triggerimpulse zur Bestimmung des Stellsignals dient, wird vorzugsweise in einem Bereich eingestellt, der durch den oberen und unteren Spannungspegel der Triggerimpulse und die relative Impulsbreite des Analogsignals definiert wird. Als besonders vorteilhaft hat sich herausgestellt, das Referenzsignal aus einem Regelbereich zu wählen, der durch die Summe des unteren Spannungspegels $U_l$ der Triggerimpulse und dem doppelten Produkt des Quotienten von Pulsdauer $T_P$ und Periode $T_A$ des Analogsignals mit der Differenz des oberen und unteren Spannungspegels $U_h$ bzw. $U_l$ der Triggerimpulse bzw. durch die Summe aus unterem Spannungspegel $U_l$ der Triggerimpulse und der halben Differenz von oberem Spannungspegel $U_h$ und unterem Spannungspegel $U_l$ der Triggerimpulse begrenzt wird (Der beschriebene Bereich soll im weiteren Verlauf bezeichnet werden durch:

$$[U_l + 2\, T_P/T_A\, (U_h - U_l),\ U_l + \tfrac{1}{2}\, (U_h - U_l)]).$$

Zur Umsetzung der Analogsignale in Rohimpulse wird ein Triggermodul verwendet, das für die Zeit, in der das Analogsignal einen Schwellwert überschreitet, den Rohimpuls erzeugt. Als Triggermodul wird insbesondere ein Komparator verwendet.

Die Umwandlung der Rohimpulse in Triggerimpulse wird vorzugsweise in einem ersten regelbaren Impulsgenerator durchgeführt. Insbesondere handelt es sich hierbei um einen ersten mit einem Regeleingang ausgestatteten Monovibrator. Dieser Regeleingang erlaubt es, mit dem dort anliegenden Stellsignal die Länge der Triggerimpulse zu steuern und gleichzeitig den Eingang des Monovibrators während der Ausgabe des Triggerimpulses zu sperren.

Der zum Vergleich mit dem Referenzsignal benötigte Mittelwert der Folge der Triggerimpulse wird bevorzugt durch einen Tiefpaß gebildet. Der Vergleich der gemittelten Triggerimpulse und des Referenzsignals findet vorzugsweise in einem Regler insbesondere einem PID-Regler statt, der als Ergebnis das Stellsignal liefert, dessen Wert der Impulslänge entspricht. Der Regler verändert dabei so lange das Stellsignal und somit die Impulslänge, bis der Mittelwert der Triggerimpulse dem Referenzsignal entspricht.

Die Umsetzung der Triggerimpulse mit veränderlicher Impulslänge in Endimpulse mit definierter Höhe und definierter Breite wird bevorzugt in einem zweiten Impulsgenerator insbesondere einem zweiten Monovibrator durchgeführt.

Der folgende Teil der Beschreibung bezieht sich auf eine elektrische Schaltung zur Umsetzung des erfindungsgemäßen Verfahrens.

Die Aufgabe der vorliegenden Erfindung soll weiterhin sein, eine elektrische Schaltung zur Umwandlung stark strukturierter, mit variabler Pulsfrequenz eintreffender Analogsignale in Triggerimpulse bereitzustellen, die sich für eine bestimmte Zeit, die sogenannte Totzeit, verriegelt.

Zur Lösung der Aufgabe ist eine elektrische Schaltung der vorbeschriebenen Art erfindungsgemäß durch die Merkmale von Anspruch 11 gekennzeichnet.

Die Schaltung enthält bevorzugt vier aktive Komponenten, wobei ein Triggermodul die Analogsignale, solange sie einen Schwellwert überschreiten, in Rohimpulse mit einer definierten Spannung umwandelt. Vorteilhaft überführt ein erster Impulsgenerator, der einen Regeleingang besitzt, diese Rohimpulse in Triggerimpulse mit veränderlicher Impulslänge und fester Impulshöhe. Diese Impulslänge wird dabei über ein Stellsignal auf dem Regeleingang gesteuert. Während der Ausgabe der Triggerimpulse ist der Eingang des ersten Impulsgenerators gesperrt. Eine dritte Komponente bildet vorzugsweise den zeitlichen Mittelwert der Folge der Triggerimpulse, der in einem Regler mit einem Referenzsignal verglichen wird. Als Ergebnis dieses Vergleichs wird das Stellsignal auf den Regeleingang des ersten Impulsgenerators geschaltet und regelt die Länge der Triggerimpulse, die der Totzeit entspricht. Der Regler ändert solange das Stellsignal und somit die Impulslänge, bis der zeitliche Mittelwert der Folge der Triggerimpulse und das Referenzsignal übereinstimmen. Diese Triggerimpulse weisen eine feste Impulshöhe auf und dienen mit ihrem steilen Signalanstieg als hochgenaue Zeitmarke und Beginn eines Ereignisses.

Der Aufbau der elektrischen Schaltung kann mit unterschiedlichen Komponenten oder mit an die Aufgaben angepasste Baugruppen realisiert werden. Bei einer bevorzugten Ausführungsform ist das Triggermodul ein Komparator, der das Analogsignal mit einem Schwellwert vergleicht und einen Rohimpuls ausgibt, solange das Ausgangssignal den Schwellwert überschreitet. Der erste Impulsgenerator ist vorteilhaft als ein Monovibrator mit Regeleingang ausgebildet. Bei der dritten Komponente, die die zeitliche Mittelwertbildung über die Folge der Triggerimpulse durchführt, handelt es sich bevorzugt um einen Tiefpaß. Der Regler ist vorzugsweise als PID-Regler ausgebildet.

Die Erfindung wird im folgenden anhand einer in einer Zeichnung dargestellten Ausführungsform näher beschrieben, aus der sich weitere Einzelheiten, Merkmale und Vorzüge ergeben.

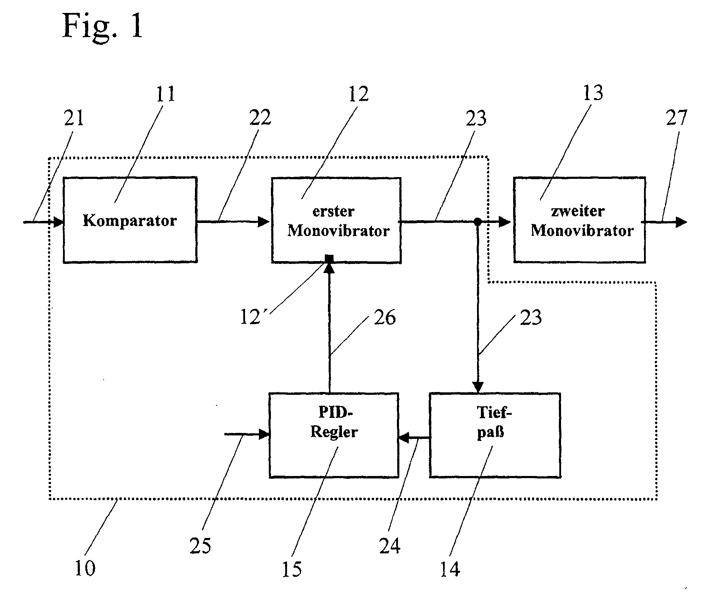

Die Figur zeigt eine in einem Blockdiagramm dargestellte Ausführungsform einer elektrischen Schaltung zur Umwandlung stark strukturierter, mit variabler Pulsfrequenz eintreffender Analogsignale in Triggerimpulse.

Bei dem in der Figur gezeigten Blockdiagramm handelt es sich um eine Ausführungsform einer elektrischen Schaltung 10 zur Umwandlung stark strukturierter, mit variabler Pulsfrequenz eintreffender Analogsignale 21 in Triggerimpulse 23 und einem nachgeschalteten zweiten Monovibrator 13 zur Umwandlung der Triggerimpulse 23 in Endimpulse 27 mit definierter Höhe und definierter Breite. Die analogen Signale 21 treffen zunächst auf den als Triggermodul geschalteten Komparator 11, in den Rohimpulse 22 mit definierter Spannung abgeleitet werden, solange das Analogsignal den Schwellwert überschreitet. Bei stark strukturierten Analogsignalen mit Einbrüchen unterhalb des Schwellwertes sind Mehrfachtriggerungen hier ohne weiteres noch möglich, weil die Rohsignale unterbrochen werden, sobald das Analogsignal unter den Schwellwert sinkt, auch wenn dies innerhalb eines Pulses des strukturierten Analogsignals geschieht.

Die Rohimpulse 22 werden auf den Eingang des als erster Impulsgenerator verwendeten ersten Monovibrators 12 mit Regeleingang 12' gegeben, der im nicht gesperrten Zustand auf jeden Rohimpuls 22 mit einem Triggerimpuls 23 antwortet, dessen Länge über den Regeleingang 12' des Monovibrators 12 durch das dort anliegende Stellsignal 26 definiert wird. Der Eingang des ersten Monovibrators 12 ist während der Ausgabe der Triggerimpulse 23 gesperrt, so dass die Länge der Triggerimpulse 23 der Totzeit entspricht.

Das zur Bestimmung der Impulslänge benötigte Stellsignal 26 wird aus den Triggerimpulsen 23 abgeleitet. Hierzu wird der zeitliche Mittelwert 24 der Folge der Triggerimpulse 23, wie in diesem Ausführungsbeispiel dargestellt, durch einen Tiefpaß 14 mit abgestimmter Grenzfrequenz gebildet. Dieser zeitliche Mittelwert 24 ist in charakteristischer Weise von der Impulslänge und weiter davon abhängig, ob es zu Mehrfachtriggerungen durch zerklüftete Analogsignale kommt oder nicht.

Die Regelung wird in einem PID-Regler 15 durchgeführt. Hier wird zwischen dem zeitlichen Mittelwert 24 und dem Referenzsignal 25, das auf einen Wert im Bereich $[U_l + 2\,T_P/T_A\,(U_h - U_l),\ U_l + \frac{1}{2}\,(U_h - U_l)]$ eingestellt ist, ein Soll/Ist-Vergleich durchgeführt und das Stellsignal 26 für den Regeleingang 12' des ersten Monovibrators 12 abgeleitet. Dies geschieht derart, dass der PID-Regler das Stellsignal 26 variiert, bis der Mittelwert 24 mit dem Referenzsignal 25 übereinstimmt.

Für bestimmte Anforderungen ist es wünschenswert, Triggerimpulse mit einer definierten, festen Impulslänge zu erhalten. Hierfür ist in dem dargestellten Ausführungsbeispiel ein zweiter Monovibrator 13 nachgeschaltet, der an den positiven Flanken der Triggerimpulse 23 die Endimpulse 27 mit definierter Höhe und definierter Breite ableitet. Die Umsetzung ändert allerdings nichts daran, dass die Triggerimpulse selbst schon zeitlich hochgenaue Marken darstellen. Nur kann es für manche Anwendungen von Vorteil sein, Triggerimpulse mit einer definierten, konstanten Impulslänge, also Endimpulse, ausgeben zu können.

Mit diesem Verfahren können z. B. bei einer Pulsfrequenz der Analogsignale von 0,04 bis 40 kHz und bei einem Verhältnis der Pulslänge zur Periode der Analogsignale von 0,7 bis 14,0% die Analogsignale mit einem Referenzsignal von $U_l + 0,37\,(U_h - U_l)$ sicher abgedeckt werden, wobei die Eindeutigkeitsgrenze der Regelung groß genug ist, um bei Schwankungen, die bei schnellen Pulsfrequenzänderungen auftreten, fehlerfreie Ergebnisse zu liefern.

**Patentansprüche**

1. Verfahren zur Umwandlung stark strukturierter, mit variabler Pulsfrequenz eintreffender Analogsignale (21) in Triggerimpulse (23) mittels einer Elektronik (10), wobei diese für eine bestimmte Zeit, die sog. Totzeit, verriegelt wird, wobei die Totzeit an die aktuelle Pulsfrequenz der Analogsignale angepasst wird, **dadurch gekennzeichnet, dass**

   - die Analogsignale (21) beim Überschreiten eines Schwellwertes in Rohimpulse (22) mit einer definierten Spannung umgewandelt werden;
   - die Rohimpulse (22) dann in Triggerimpulse (23) mit einer veränderlichen Impulslänge, die der Totzeit entspricht, und einer festen Impulshöhe überführt werden;
   - die Impulslänge über ein Stellsignal (26) bestimmt wird;
   - das Stellsignal durch einen Vergleich des zeitlichen Mittelwerts (24) der Triggerimpulse (23) mit einem Referenzsignal (25) erzeugt wird.

2. Verfahren nach Anspruch 1, **dadurch gekennzeichnet, dass** die Triggerimpulse (23) in Endimpulse (27) mit definierter Höhe und definierter Breite umgewandelt werden.

3. Verfahren nach Anspruch 1 oder 2, **dadurch gekennzeichnet, dass** das Referenzsignal (25) in einem Regelbereich definiert wird, der durch den oberen und unteren Spannungspegel der Triggerimpulse (23) und die relative Impulsbreite des Analogsignals (21) definiert ist.

4. Verfahren nach einem der vorhergehenden Ansprüche, **dadurch gekennzeichnet, dass** eine linke Regelbereichsgrenze bestimmt wird durch die Summe des unteren Spannungspegels der Triggerimpulse (23) und dem doppelten Produkt des Quotienten von Pulsdauer und Periode des Analogsignals (21) mit der Differenz des oberen und unteren Spannungspegels der Triggerimpulse (23), und eine rechte Regelbereichsgrenze durch die Summe aus unterem Spannungspegel $U_l$ der Triggerimpulse und der halben Differenz von oberem Spannungspegel $U_h$ und unterem Spannungspegel $U_l$ der Triggerimpulse (23), was im folgenden abgekürzt wird durch: $[U_l + 2\,T_P/T_A\,(U_h - U_l),\ U_l + \frac{1}{2}\,(U_h - U_l)]$

5. Verfahren nach einem oder mehreren der vorausgehenden Ansprüche, **dadurch gekennzeichnet, dass** Umsetzung der Analogsignale (21) in Rohimpulse (22) in einem Triggermodul insbesondere einem Komparator (11) durchgeführt wird.

6. Verfahren nach einem oder mehreren der vorausgehenden Ansprüche, **dadurch gekennzeichnet, dass** die Umwandlung der Rohimpulse (22) in die Triggerimpulse (23) in einem ersten regelbaren Impulsgenerator insbesondere einem ersten Monovibrator (12) mit Regeleingang (12') durchgeführt wird.

7. Verfahren nach Anspruch 6, **dadurch gekennzeichnet, dass** durch den Regeleingang des ersten Impulsgenerators die Länge der Triggerimpulse (23) gesteuert und gleichzeitig während der Ausgabe der Triggerimpulse (23) der Eingang des ersten Impulsgenerators gesperrt wird.

8. Verfahren nach einem oder mehreren der vorausgehenden Ansprüche, **dadurch gekennzeichnet, dass** die zeitliche Mittelwertbildung der Triggerimpulse (23) mit einem Tiefpaß (14) durchgeführt wird.

9. Verfahren nach einem oder mehreren der vorausgehenden Ansprüche, **dadurch gekennzeichnet, dass** der Vergleich zwischen dem zeitlichen Mittelwert (24) der Triggerimpulse (23) und dem Referenzsignal (25) in einem Regler insbesondere in einem PID-Regler (15) ausgeführt wird.

10. Verfahren nach einem oder mehreren der vorausgehenden Ansprüche, **dadurch gekennzeichnet, dass** die Umwandlung der Triggerimpulse (23) in Endimpulse (27) in einem zweiten Impulsgenerator insbesondere einem zweiten Monovibrator (13) durchgeführt wird.

11. Elektrische Schaltung zur Umwandlung stark strukturierter, mit variabler Pulsfrequenz eintreffender Analogsignale (21) in Triggerimpulse (23) die sich für eine bestimmte Zeit, die sog. Totzeit, verriegelt, wobei sie die Totzeit an die aktuelle Pulsfrequenz der Analogsignale anpasst, **dadurch gekennzeichnet, dass**

   - sie ein Triggermodul enthält, das die Analogsignale (21) beim Überschreiten eines Schwellwertes in Rohimpulse (22) mit definierter Spannung umwandelt;
   - ein erster Impulsgenerator folgt, der die Rohimpulse (22) in Triggerimpulse (23) mit einer der Totzeit entsprechenden veränderlichen Impulslänge und einer festen Impulshöhe überführt;
   - der erste Impulsgenerator einen Regeleingang besitzt;
   - eine dritte Komponente die zeitliche Mittelwertbildung der Triggerimpulse (23) durchführt;
   - ein Regler den Mittelwert (24) der Triggerimpulse mit einem Referenzsignal (25) vergleicht;
   - das Ergebnis dieses Vergleichs als Stellsignal (26) auf den Regeleingang des ersten Impulsgenerators trifft, um die Länge der Triggerimpulse zu steuern und den Eingang zu sperren.

12. Elektrische Schaltung nach einem oder mehreren der vorausgehenden Ansprüche, **dadurch gekennzeichnet, dass** das Triggermodul als Komparator (11) ausgebildet ist.

13. Elektrische Schaltung nach Anspruch 11, **dadurch gekennzeichnet, dass** der erste Impulsgenerator als erster Monovibrator (12) mit Regeleingang (12') ausgebildet ist.

14. Elektrische Schaltung nach einem oder mehreren der vorausgehenden Ansprüche, **dadurch gekennzeichnet, dass** die dritte Komponente als Tiefpaß (14) ausgebildet ist.

15. Elektrische Schaltung nach einem oder mehreren der vorausgehenden Ansprüche, **dadurch gekennzeichnet, dass** der Regler als PID-Regler (15) ausgebildet ist.

**Claims**

1. A process for converting highly structured analogue signals (21) arriving with variable pulse frequency into trigger pulses (23) by means of an electronic system (10), said electronic system (10) being locked for a given time, the so-called "dead time", the dead time being matched to the current pulse frequency of the analogue signals, **characterised in that**

   - the analogue signals (21) are converted into raw pulses (22) with a defined voltage when a threshold value is exceeded,
   - the raw pulses (22) are then converted into trigger pulses (23) with a variable pulse length corresponding to the dead time and a fixed pulse height,
   - the pulse length is determined by a positioning signal (25),
   - the positioning signal is generated by a comparison of the time average (24) of the trigger pulses (23) with a reference signal (25).

2. A process in accordance with claim 1, **characterised in that** the trigger pulses (23) are converted into final pulses (27) of defined height and defined width.

3. A process in accordance with claim 1 or 2, **characterised in that** the reference signal (25) is defined in a control range which is defined by the upper and lower voltage levels of the trigger pulses (23) and the relative pulse width of the analogue signal (21).

4. A process in accordance with one of the preceding claims, **characterised in that** a left control range limit is determined by the sum of the lower voltage level of the trigger pulses (23) and twice the product of the quotients of pulse duration and period of the analogue signal (21) with the difference between the upper and lower voltage levels of the trigger pulses (23), and a right control range limit is determined by the sum of the lower voltage level ($U_l$) of the trigger pulses and half the difference between the upper voltage level ($U_h$) and the lower voltage level ($U_l$) of the trigger pulses (23), hereinafter abbreviated as: $[U_l + 2\, T_P/T_A(U_h - U_l),\ U_l + \frac{1}{2}(U_h - U_l)]$.

5. A process in accordance with one or more of the preceding claims, **characterised in that** conversion of the analogue signals (21) into raw pulses (22) is carried out in a trigger module, in particular a comparator.

**6.** A process in accordance with one or more of the preceding claims,
**characterised in that**
the conversion of the raw pulses (22) into the trigger pulses (23) is carried out in a first controllable pulse generator, in particular a first monovibrator (12) with control input (12').

**7.** A process in accordance with claim 6,
**characterised in that**
the length of the trigger pulses (23) is controlled by the control input of the first pulse generator and at the same time the input of the first pulse generator is blocked during the outputting of the trigger pulses (23).

**8.** A process in accordance with one or more of the preceding claims,
**characterised in that**
the time averaging of the trigger pulses (23) is carried out using a low-pass filter (14).

**9.** A process in accordance with one or more of the preceding claims,
**characterised in that**
the comparison of the time average (24) of the trigger pulses (23) and the reference signal (25) is carried out in a controller, in particular a PID controller (15).

**10.** A process in accordance with one or more of the preceding claims,
**characterised in that**
the conversion of the trigger pulses (23) into final pulses (27) is carried out in a second pulse generator, in particular a second monovibrator (13).

**11.** An electrical circuit for converting highly structured analogue signals (21) which arrive with variable pulse frequency into trigger pulses (23) and which locks itself for a given time, the so-called "dead time", matching the dead time to the current pulse frequency of the analogue signals,
**characterised in that**

- it contains a trigger module which converts the analogue signals (21) into raw pulses (22) with a defined voltage when a threshold value is exceeded,
- this is followed by a first pulse generator which converts the raw pulses (22) into trigger pulses (23) with a variable pulse length corresponding to the dead time and a fixed pulse height,
- the first pulse generator has a control input,
- a third component carries out the time averaging of the trigger pulses (23),
- a controller compares the average (24) of the trigger pulses with a reference signal (25),

- the result of this comparison hits the control input of the first pulse generator as a positioning signal (26) in order to control the length of the trigger pulses and to block the input.

**12.** An electrical circuit in accordance with one or more of the preceding claims,
**characterised in that**
the trigger module is designed as a comparator (11).

**13.** An electrical circuit in accordance with claim 11,
**characterised in that**
the first pulse generator is designed as a first monovibrator (12) with control input (12').

**14.** An electrical circuit in accordance with one or more of the preceding claims,
**characterised in that**
the third component is designed as a low-pass filter (14).

**15.** An electrical circuit in accordance with one or more of the preceding claims,
**characterised in that**
the controller is designed as a PID controller (15).

**Revendications**

**1.** Procédé pour la transformation de signaux analogiques (21) fortement structurés se réalisant avec une fréquence variable de récurrence des impulsions en impulsions de déclenchement (23) au moyen d'un dispositif électronique (10), celui-ci étant verrouillé pour un temps donné, appelé temps de retard, ledit temps de retard étant adapté à la fréquence de récurrence des impulsions actuelle des signaux analogiques, **caractérisé en ce que**
lorsqu'une valeur limite est dépassée, les signaux analogiques (21) sont transformés en impulsions brutes (22) avec une tension définie ;
les impulsions brutes (22) sont ensuite transformées en impulsions de déclenchement (23) avec une longueur d'impulsion variable, correspondant au temps de retard, et une hauteur d'impulsion fixe ;
la longueur d'impulsion est déterminée par un signal de réglage (26) ;
le signal de réglage est produit en comparant la valeur moyenne temporelle (24) des impulsions de déclenchement (23) à un signal de référence (25).

**2.** Procédé selon la revendication 1, **caractérisé en ce que** les impulsions de déclenchement (23) sont transformées en impulsions de sortie (27) avec une hauteur et une largeur définies.

**3.** Procédé selon la revendication 1 ou 2, **caractérisé**

**en ce que** le signal de référence (25) est défini dans une plage de réglage, elle-même définie par le niveau de tension haut et bas des impulsions de déclenchement (23) et la largeur d'impulsion relative du signal analogique (21).

4. Procédé selon l'une des revendications précédentes, **caractérisé en ce qu'**une limite de plage de réglage gauche est déterminée par la somme du niveau de tension bas des impulsions de déclenchement (23) et du double du produit du quotient de la durée d'impulsion et de la période du signal analogique (21) avec la différence du niveau de tension haut et bas des impulsions de déclenchement (23), et une limite de plage de réglage droite par la somme du niveau de tension bas $U_l$ des impulsions de déclenchement et de la moitié de la différence du niveau de tension haut $U_h$ et du niveau de tension bas $U_l$ des impulsions de déclenchement (23), ce qui est abrégé ci-après par : $[U_l+2T_p/T_A(U_h-U_l), U_l+\frac{1}{2}(U_h-U_l)]$

5. Procédé selon l'une quelconque des revendications précédentes, **caractérisé en ce que** la conversion des signaux analogiques (21) en impulsions brutes (22) est effectuée dans un module de déclenchement, notamment un comparateur (11).

6. Procédé selon l'une quelconque des revendications précédentes, **caractérisé en ce que** la transformation des impulsions brutes (22) en impulsions de déclenchement (23) est effectuée dans un premier générateur d'impulsions variable, notamment un premier monostable (12) avec une entrée de réglage (12').

7. Procédé selon la revendication 6, **caractérisé en ce que** la longueur des impulsions de déclenchement (23) est réglée par l'entrée de réglage du premier générateur d'impulsions et simultanément arrêtée pendant l'émission des impulsions de déclenchement (23) de l'entrée du premier générateur d'impulsions.

8. Procédé selon l'une quelconque des revendications précédentes, **caractérisé en ce que** la valeur moyenne temporelle des impulsions de déclenchement (23) est générée au moyen d'un filtre passe-bas (14).

9. Procédé selon l'une quelconque des revendications précédentes, **caractérisé en ce que** la comparaison entre la valeur moyenne temporelle (24) des impulsions de déclenchement (23) et le signal de référence (25) est réalisée dans un régulateur, notamment dans un régulateur PID (15).

10. Procédé selon l'une quelconque des revendications précédentes, **caractérisé en ce que** la transformation des impulsions de déclenchement (23) en impulsions de sortie (27) est effectuée dans un deuxième générateur d'impulsions, notamment un deuxième monostable (13).

11. Circuit électrique pour la transformation des signaux analogiques (21) fortement structurés se réalisant avec une fréquence variable de récurrence des impulsions en impulsions de déclenchement (23) qui se verrouillent pour un temps donné, appelé temps de retard, moyennant quoi il adapte le temps de retard à la fréquence de récurrence des impulsions actuelle des signaux analogiques, **caractérisé en ce que**

il comprend un module de déclenchement qui transforme les signaux analogiques (21) en impulsions brutes (22) avec une tension définie lors du dépassement d'une valeur limite ;

un premier générateur d'impulsions transforme ensuite les impulsions brutes (22) en impulsions de déclenchement (23) avec une longueur d'impulsion variable, correspondant au temps de retard, et une hauteur d'impulsion fixe ;

le premier générateur d'impulsions possède une entrée de réglage ;

un troisième composant génère la valeur moyenne temporelle des impulsions de déclenchement (23) ;

un régulateur compare la valeur moyenne (24) des impulsions de déclenchement à un signal de référence (25) ;

le résultat de cette comparaison rencontre en tant que signal de réglage (26) l'entrée de réglage du premier générateur d'impulsions afin de régler la longueur des impulsions de déclenchement et d'arrêter l'entrée.

12. Circuit électrique selon l'une quelconque des revendications précédentes, **caractérisé en ce que** le module de déclenchement est formé comme un comparateur (11).

13. Circuit électrique selon la revendication 11, **caractérisé en ce que** le premier générateur d'impulsions est formé comme un premier monostable (12) avec une entrée de réglage (12').

14. Circuit électrique selon l'une quelconque des revendications précédentes, **caractérisé en ce que** le troisième composant est formé comme un filtre passe-bas (14).

15. Circuit électrique selon l'une quelconque des revendications précédentes, **caractérisé en ce que** le régulateur est formé comme un régulateur PID (15).

# Fig. 1